# EUROPÄISCHE PATENTSCHRIFT

(11) **EP 3 698 158 B1**
(45) Veröffentlichungstag und Bekanntmachung des Hinweises auf die Patenterteilung: **24.04.2024**
(21) Anmeldenummer: 18788692.4
(22) Anmeldetag: 08.10.2018
(51) Int. Cl.: G01R 35/00, G01R 19/00

(54) **SPANNUNGSMESSVERFAHREN, BETRIEBSVERFAHREN UND STEUEREINRICHTUNG FÜR EIN BORDNETZ SOWIE BORDNETZ UND FAHRZEUG**
VOLTAGE MEASUREMENT METHOD, OPERATING METHOD AND CONTROL DEVICE FOR A VEHICLE ELECTRICAL SYSTEM, AND VEHICLE ELECTRICAL SYSTEM AND VEHICLE
PROCÉDÉ DE MESURE DE TENSION, PROCÉDÉ DE FONCTIONNEMENT ET DISPOSITIF DE COMMANDE POUR UN RÉSEAU DE BORD AINSI QUE RÉSEAU DE BORD ET VÉHICULE AUTOMOBILE

(30) Priorität: 19.10.2017 DE 102017218732
(43) Veröffentlichungstag der Anmeldung: 26.08.2020
(73) Patentinhaber: Volkswagen Aktiengesellschaft, 38440 Wolfsburg (DE)
(72) Erfinder: JUHL, Jochen, 31702 Lüdersfeld (DE); HOLLINGER, Jochen, 76829 Landau (DE)
(86) Internationale Anmeldenummer: PCT/EP2018/077302
(87) Internationale Veröffentlichungsnummer: WO 2019/076662

(56) Entgegenhaltungen:
- DE-A1-102006 050 529
- DE-A1-102009 047 608
- DE-A1-102016 115 867
- DE-B3-102014 018 643
- US-A1- 2005 017 734

## Beschreibung

Die vorliegende Erfindung betrifft ein Spannungsmessverfahren, ein Betriebsverfahren und eine Steuereinrichtung für ein Bordnetz sowie ein Bordnetz und ein Fahrzeug als solche.

Bei vielen Fahrzeugkonzepten, die zumindest teilweise auf elektrischen Betrieb setzen, finden in Bordnetzen vermehrt batteriebasierte Hochspannungsnetze im Zusammenwirken mit weiteren Netzen, zum Beispiel mit Traktionsnetzen, Niederspannungsnetzen und Ladenetzen, Anwendung. Bei derartigen Bordnetzen ist für den sicheren Betrieb die Kenntnis elektrischer Betriebsparameter, insbesondere von Spannungen innerhalb der Teilnetze, erforderlich. Eine weitere Randbedingung ist das Einhalten einer gewissen Messgenauigkeit beim Bestimmen der Werte der Spannungen. Der für eine derartige Genauigkeit erforderliche Messaufwand ist bisher mit entsprechenden Mehrkosten verbunden, die durch bekannte Techniken nicht vermieden werden können, soll es zu keinen Genauigkeitseinbußen kommen.

Der Erfindung liegt die Aufgabe zu Grunde, Spannungsmessverfahren, Betriebsverfahren und eine Steuereinheit für ein Bordnetz sowie ein Bordnetz und ein Fahrzeug als solche anzugeben, bei welchen mit besonders einfachen und kostengünstigen Mitteln die Ermittlung von Werten einer Spannung in einem Teilnetz mit hoher Zuverlässigkeit möglich ist.

DE 10 2004 057 694 A1 betrifft ein Bordnetz mit höherer Spannung, bei welcher hochspannungsseitig eine Fehlerstromschutzschaltung vorgesehen ist, welche ohne Strommessung arbeitet.

US 8,779,784 B2 beschreibt einen Messkreis für Isolationswiderstände unter Verwendung einer Anordnung integrierter Widerstände. Aus den DE 10 2006 050 529 B4, DE 10 2016 115 867 A1 und DE 10 2014 018 643 B3 sind weitere Bordnetze mit mehreren Spannungsmessvorrichtungen bekannt. Die DE 10 2009 047 608 A1 und US 2005 / 0017734 A1 offenbaren verschiedene Kalibrierverfahren für Spannungsmessvorrichtungen.

Die der Erfindung zu Grunde liegende Aufgabe wird bei einem Spannungsmessverfahren erfindungsgemäß mit den Merkmalen des Patentanspruchs 1, bei einem Betriebsverfahren erfindungsgemäß mit den Merkmalen des Patentanspruchs 6, bei einer Steuereinheit erfindungsgemäß mit den Merkmalen des Patentanspruchs 7, bei einem Bordnetz erfindungsgemäß mit den Merkmalen des Anspruchs 8 sowie bei einem Fahrzeug erfindungsgemäß mit den Merkmalen des Patentanspruchs 9 gelöst. Vorteilhafte Weiterbildungen sind Gegenstand der jeweiligen abhängigen Ansprüche.

Gemäß einem ersten Aspekt der vorliegenden Erfindung wird ein Spannungsmessverfahren für ein Bordnetz eines Fahrzeugs geschaffen, welches ein Hochspannungsnetz und mindestens ein weiteres Netz aufweist, wobei im Bordnetz
(i) das Hochspannungsnetz mit einer über eine erste Leitung und über eine zweite Leitung elektrisch mit einem positiven Anschluss bzw. einem negativen Anschluss einer Hochspannungsquelle elektrisch verbindbaren oder verbundenen Spannungsmesseinrichtung ausgebildet ist und
(ii) das weitere Netz mit über Schütze mit der ersten Leitung bzw. der zweiten Leitung des Hochspannungsnetzes elektrisch verbindbaren ersten bzw. zweiten Leitungen und mit einer mit diesen elektrisch verbindbaren oder verbundenen weiteren Spannungsmesseinrichtung ausgebildet ist.

Erfindungsgemäß wird bei dem vorgeschlagenen Verfahren
(iii) im Kalibrationsbetrieb bei geschlossenen Schützen die Spannungsmesseinrichtung des weiteren Netzes gegen die Spannungsmesseinrichtung des Hochspannungsnetzes unter Ableitung mindestens eines Kalibrationsparameters kalibriert und
(iv) im Messbetrieb eine Spannungsmessung in dem weiteren Netz mit der Spannungsmesseinrichtung des weiteren Netzes und unter Abgleich mittels des Kalibrationsparameters durchgeführt.

Erfindungsgemäß wird im Kalibrationsbetrieb ein jeweiliger Kalibrationsparameter gemeinsam mit einem oder mit mehreren Betriebsparametern des Hochspannungsnetzes und/oder des weiteren Netzes erfasst und insbesondere gespeichert. Im Messbetrieb wird beim Abgleich über einen oder mehrere Betriebsparameter des Hochspannungsnetzes und/oder des weiteren Netzes und insbesondere über eine Betriebstemperatur ein jeweiliger Kalibrationsparameter identifiziert und auf diesen zurückgegriffen. Somit ist auf einfache Weise eine Identifikation zwischen Betriebsparametern der zu Grunde liegenden Aggregate und/oder des zu Grunde liegenden Fahrzeugs mit entsprechenden Kalibrationsparametern angegeben, um dadurch für jeden Betriebszustand, definiert durch die Betriebsparameter, den entsprechenden vorab bestimmten Kalibrationsparameter auffinden zu können.

Auf Grund der Kalibration mit der Spannungsmesseinrichtung des Hochspannungsnetzes ist es erfindungsgemäß möglich, die Spannungsmessung im weiteren Netz auf die Genauigkeit der Spannungsmesseinrichtung des Hochspannungsnetzes zurückzuführen, so dass im weiteren Netz kostengünstigere Messeinrichtungen und Messverfahren eingesetzt und damit der apparative Aufwand und Investitionskosten reduziert werden können. Um Alterungseffekten vorzubeugen kann es vorteilhaft sein, den Kalibriervorgang mehrfach über die Lebensdauer zu wiederholen.

Eine Messung im Traktionsnetz (TN) kann insbesondere auf eine batterieinterne Messung zwischen positiven und negativen Batterieanschlüssen (BAT+, BAT-) zurückgeführt werden.

Denkbar und vorteilhaft ist die Durchführung einer Kalibration als Lernverfahren oder als ein Verfahren, welches parallel während des eigentlichen Betriebs eines Bordnetzes durchgeführt wird.

Bei einer anderen vorteilhaften Ausgestaltungsform des erfindungsgemäßen Spannungsmessverfahrens werden im Kalibrationsbetrieb erfasste Kalibrationsparameter in einer Nachschlagetabelle, insbesondere codiert nach einem oder mehreren Betriebsparametern des Hochspannungsnetzes und/oder des weiteren Netzes, z.B. einer Betriebstemperatur, gespeichert.

Es stellen sich besonders einfache Verhältnisse ein, wenn gemäß einer anderen bevorzugten Ausführungsform des erfindungsgemäßen Spannungsmessverfahrens ein jeweiliger Kalibrationsparameter als Faktor abgeleitet wird und im Messbetrieb ein Abgleich dadurch erfolgt, dass der Wert einer durch die Spannungsmesseinrichtung des weiteren Netzes ermittelten Spannung mit dem Kalibrationsparameter multipliziert wird, um einen korrigierten Wert der Spannung zu erhalten.

Die Genauigkeit des erfindungsgemäßen Spannungsmessverfahrens kann weiter gesteigert werden, indem ein Kalibrationsbetrieb wiederholt durchgeführt wird. Auf diese Weise ist mit einfachen Mitteln eine ständige Anpassung an sich ändernde Betriebsbedingungen und an andere Umstände - z.B. des Betriebs und/oder eines Zustands eines zu Grunde liegenden Fahrzeugs und/oder Fahrzeugaggregats - möglich.

Dabei ist es von besonderem Vorteil, wenn ein Kalibrationsbetrieb durchgeführt wird, sobald ein Kriterium oder mehrere Kriterien aus der Gruppe von Kalibrationskriterien erfüllt ist bzw. sind, welche unter anderem die folgenden Kriterien aufweist:
(i) der Wert einer Betriebstemperatur eines zu Grunde liegenden Fahrzeugs und/oder eines Aggregats des Fahrzeugs liegt außerhalb einer bestimmten Wertemenge,
(ii) der Betrieb des Fahrzeugs und/oder eines Aggregats des Fahrzeugs wurde erstmalig begonnen,
(iii) der Betrieb des Fahrzeugs und/oder eines Aggregats des Fahrzeugs wurde erneut begonnen, insbesondere nach Verstreichen einer vorgegebenen Zeitspanne,
(iv) es ist eine bestimmte Zeitspanne seit einer letzten Kalibration verstrichen,
(v) der Wert der Abweichung zwischen einem mit der Spannungsmesseinrichtung des Hochspannungsnetzes bestimmten Wert und einem mit der Spannungsmesseinrichtung des weiteren Netzes bestimmten Wert liegt außerhalb einer vorgegebenen Wertemenge.

In diesem Zusammenhang kann unter einem erstmaligen Betrieb verstanden werden, ein erstmaliger Betrieb nach der Produktion, insbesondere also bei einem Kunden, ein tatsächlich erstmaliger Motorstart, der insbesondere noch während der Produktion durchgeführt wird, oder eine Wiederaufnahme des Betriebs, zum Beispiel nach einer Standzeit ohne Betrieb und von vorgegebener Mindestdauer.

Bei einer anderen vorteilhaften Weiterbildung des erfindungsgemäßen Spannungsmessverfahrens wird mindestens ein weiteres Netz von einem Traktionsnetz und/oder von einem Ladenetz, insbesondere von einem Gleichspannungsladenetz, gebildet. Insgesamt kann eine Mehrzahl von weiteren Netzen ausgebildet sein, welche mit dem Hochspannungsnetz elektrisch gekoppelt sind, zum Beispiel ein Traktionsnetz, ein Ladenetz, und ein Niederspannungsnetz, welches der Versorgung weiterer Aggregate des Fahrzeugs dienen und zum Beispiel ein 12V-Netz und/oder ein 48V-Netz umfassen kann.

Gemäß einem weiteren Aspekt der vorliegenden Erfindung wird auch ein Betriebsverfahren für ein aus einem Hochspannungsnetz und mindestens einem weiteren Netz bestehendes Bordnetz eines Fahrzeugs geschaffen, wobei der Betrieb des Hochspannungsnetzes und/oder des mindestens einen weiteren Netzes über ein Erfassen von Spannungswerten überwacht und/oder gesteuert wird und zum Erfassen der Spannungswerte ein erfindungsgemäßes Spannungsmessverfahrens verwendet wird.

Ferner schafft die vorliegende Erfindung eine Steuereinheit für ein aus einem Hochspannungsnetz und mindestens einem weiteren Netz bestehendes Bordnetz eines Fahrzeugs. Die Steuereinheit ist eingerichtet, ein erfindungsgemäßes Spannungsmessverfahren und/oder ein erfindungsgemäßes Betriebsverfahren auszuführen.

Schließlich ist Gegenstand der vorliegenden Erfindung auch ein Bordnetz für ein Fahrzeug und insbesondere für ein Elektrofahrzeug oder ein Hybridfahrzeug, welches als Bordnetz ein Hochspannungsnetz und mindestens ein weiteres Netz aufweist und welches mit einer erfindungsgemäßen Steuereinheit zur Steuerung des Betriebs und insbesondere des Ladens und/oder Entladens einer dem Bordnetz zu Grunde liegenden Batterieeinheit ausgebildet ist.

Ferner wird durch die vorliegende Erfindung auch ein Fahrzeug und insbesondere ein Elektrofahrzeug oder Hybridfahrzeug mit einem Aggregat und insbesondere mit einem Antrieb sowie mit einem erfindungsgemäßen Bordnetz zur Versorgung des Aggregats mit elektrischer Energie definiert.

### Kurzbeschreibung der Figuren

Weitere Einzelheiten, Merkmale und Vorteile der Erfindung ergeben sich aus der nachfolgenden Beschreibung und den Figuren.
- Figur 1: zeigt schematisch ein Bordnetz, welches im Zusammenhang mit einem erfindungsgemäßen Betriebsverfahren und/oder einem erfindungsgemäßen Spannungsmessverfahrens verwendet werden kann.
- Figur 2: zeigt ein Flussdiagramm einer Ausführungsform des erfindungsgemäßen Spannungsmessverfahrens.

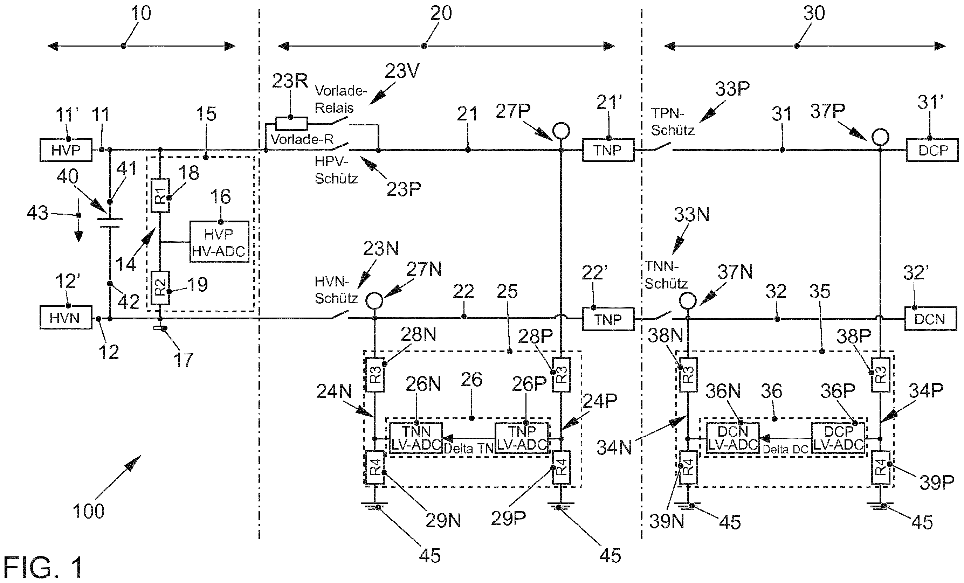

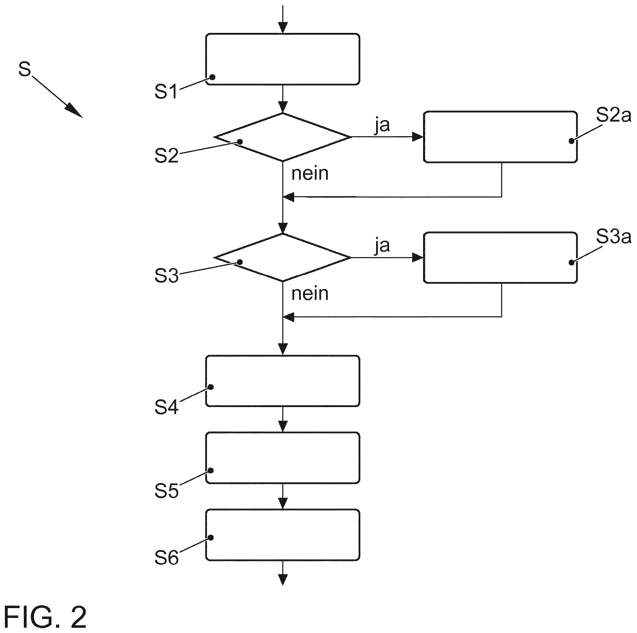

Nachfolgend werden unter Bezugnahme auf die Figuren 1 und 2 Ausführungsbeispiele und der technische Hintergrund der Erfindung im Detail beschrieben. Gleiche und äquivalente sowie gleich oder äquivalent wirkende Elemente und Komponenten werden mit denselben Bezugszeichen bezeichnet. Nicht in jedem Fall ihres Auftretens wird die Detailbeschreibung der bezeichneten Elemente und Komponenten wiedergegeben.

Die dargestellten Merkmale und weiteren Eigenschaften können in beliebiger Form voneinander isoliert und beliebig miteinander kombiniert werden, ohne den Kern der Erfindung zu verlassen.

Figur 1 zeigt schematisch ein Bordnetz 100, welches im Zusammenhang mit einem erfindungsgemäßen Betriebsverfahren und/oder einem erfindungsgemäßen Spannungsmessverfahren S verwendet werden kann.

Das in Figur 1 dargestellte Bordnetz 100 besteht in dieser Ausführungsform aus einem Hochspannungsnetz 10, einem Traktionsnetz 20, zum Beispiel zur Versorgung eines zu Grunde liegenden Antriebsaggregates, sowie einem Gleichspannungsladenetz 30, welches auch als DC-Ladenetz bezeichnet wird und welches z.B. dazu dienen kann, im Generatorbetrieb eines zu Grunde liegenden Antriebsaggregates die Batterieeinheit 40, aufgefasst als Hochspannungsbatterie des Hochspannungsnetzes 10, aufzuladen.

Die konkrete Struktur gemäß Figur 1 ist nicht zwingend, sondern nur beispielhaft. Ein erfindungsgemäßer Kernaspekt ist der Aufbau des Bordnetzes 100 aus einem Hochspannungsnetz 10 mit einer Hochspannungsbatterie 40 und mindestens einem weiteren Teilnetz 20, 30, welche hier exemplarisch als Traktionsnetz 20 und als DC-Ladenetz 30 angesprochen werden.

Das Hochspannungsnetz 10 besteht, wie eben bereits beschrieben wurde, aus einer Batterieeinheit 40, zum Beispiel einer Hochspannungsbatterie, welche eine Betriebsspannung 43 bereitstellt, zum Beispiel mit einem Wert von 450 V. Es können jedoch auch andere Betriebsspannungen und/oder andere Energiespeicherkonfigurationen mit einer Hochspannung als Betriebsspannung vorgesehen sein.

Die Batterieeinheit 40 ist elektrisch mit ihren ersten und zweiten Kontakten 41, 42 mit ersten und zweiten Leitungen 11 bzw. 12 verbunden. Auf diese Weise werden positive und negative Anschlüsse 11' bzw. 12' des Hochspannungsnetzes 10 bereitgestellt.

Innerhalb des Hochspannungsnetzes 10 ist eine erste Spannungsmesseinrichtung 15 ausgebildet. Diese ist über die ersten und zweiten Leitungen 11 und 12 mit den positiven und negativen Anschlüssen 11' bzw. 12' und folglich mit den ersten und zweiten Kontakten 41 bzw. 42 der Batterieeinheit 40 als Hochspannungsquelle verbunden oder verbindbar, um gegebenenfalls eine Spannungsmessung durchführen zu können.

Bei der in Figur 1 dargestellten Ausführungsform weist die erste Spannungsmesseinrichtung 15 einen ersten Analogdigitalwandler 16 auf, welcher über einen Spannungsteiler 14 mit Widerständen 18 und 19 mit Widerstandswerten R1 bzw. R2 mit den ersten und zweiten Leitungen 11 bzw. 12 und folglich mit der Batterieeinheit 40 einerseits und einem Bezugspotential 17 andererseits verbunden ist.

Erfindungsgemäß kann es sich bei der ersten Spannungsmesseinrichtung 15 des Hochspannungsnetzes 10 um ein hochgenaues Messsystem handeln. Ein Aspekt der vorliegenden Erfindung besteht jedoch darin, dass dies in Bezug auf Spannungsmessungen das einzige hochgenauen Messsystem im Hochspannungsnetz und den weiteren Teilnetzen ist und dass alle weiteren Spannungsmesseinrichtungen 25 und 35 in den weiteren Teilnetzen 20 und 30 Komponenten verwenden können, die weniger genau arbeiten und daher weniger aufwendig gestaltet und weniger kostenintensiv sind.

Erfindungsgemäß wird eine hohe Genauigkeit des Gesamtsystems und insbesondere bei Spannungsmessungen in den weiteren Teilnetzen 20, 30 durch die Kalibrierung in Bezug auf die hochgenaue erste Spannungsmesseinrichtung 15 des Hochspannungsnetzes 10 erzielt.

Das in Figur 1 dargestellte erste weitere Teilnetz des dort dargestellten erfindungsgemäßen Bordnetzes 100 ist ein Traktionsnetz 20 für einen zu Grunde liegenden Antrieb. Es ist über erste und zweite Leitungen 21 bzw. 22 und erste und zweite Schütze 23N bzw. 23P steuerbar mit den ersten und zweiten Leitungen 11 bzw. 12 des Hochspannungsnetzes 10 verbindbar und stellt über die ersten und zweiten Leitungen 21, 22 entsprechende positive und negative Anschlüsse 21' bzw. 22' bereit.

Auf der vom Hochspannungsnetz 10 abgewandten Seite der Schütze 23P, 23N sind Hochspannungsmesspunkte 27P und 27N für einen Abgriff durch eine Spannungsmesseinrichtung 25 des Traktionsnetzes 20 ausgebildet.

Die weitere Spannungsmesseinrichtung 25 besteht aus einem Paar von Spannungsteilern 24P und 24N, welche mit den ersten bzw. zweiten Leitungen 21 bzw. 22 und entsprechend mit den positiven und negativen Anschlüssen 21' bzw. 22' sowie einem Bezugspotential 45, welches zum Beispiel ein Chassismassepotential sein kann, verbunden sind. Zwischen den Spannungsteilern 24P, 24N ist eine Analogdigitalwandleranordnung 26 mit einem ersten Analogdigitalwandler 26P und einem zweiten Analogdigitalwandler 26N (ADC) ausgebildet, welche im Zusammenwirken einen Wert für die Potentialdifferenz zwischen den ersten und zweiten Leitungen 21 und 22 liefern. Alternativ kann eine Kombination aus Multiplexer und einem ADC zum Einsatz kommen.

Wie oben bereits erwähnt wurde, müssen die Analogdigitalwandler 26P und 26N nicht hochgenau ausgelegt sein. Das gilt auch für die Widerstände 28N, 29N sowie 28P, 29P der Spannungsteiler 24N und 24P und deren Werte R3, R4, weil durch die Kalibrierung gegen die erste und hochgenaue Spannungsmesseinrichtung 15 des Hochspannungsnetzes 10 ein Abgleich über entsprechende Kalibrierungsparameter - in Verbindung mit der aktuellen Umgebungstemperatur - erfolgt. Die Spannungsteiler können unterschiedlich ausgeführt sein, z.B. mit 28N ungleich 28P und/oder 29N ungleich 29P.

In der in Figur 1 dargestellten Anordnung für das erfindungsgemäße Bordnetz 100 ist über weitere Schütze 33P, 33N ein weiteres Teilnetz, nämlich ein DC-Ladenetz 30, mit seinen ersten und zweiten Leitungen 31, 32 mit den positiven und negativen Anschlüssen 21`, 22` des Traktionsnetzes 20 steuerbar verbindbar.

Das DC-Ladenetz 30 weist eine eigene Spannungsmesseinrichtung 35 auf, die eine ähnliche Struktur besitzt, wie die Spannungsmesseinrichtung 25 des Traktionsnetzes 20 und welche über Hochspannungsmesspunkte 37P und 37N eine Potentialdifferenz zwischen den ersten und zweiten Leitungen 31, 32 und damit zwischen den positiven und negativen Anschlüssen 31' und 32`ermitteln kann. Die Hochspannungsmesspunkte 37P und 37N liegen auf der vom Traktionsnetz 20 abgewandten Seite der ersten und zweiten Schütze 33P bzw. 33N des DC-Ladenetzes 30.

Die Spannungsmesseinrichtung 35 des DC-Ladenetzes wird gebildet von einem Paar Spannungsteiler 34P, 34N mit Widerständen 38N, 39N bzw. 38P, 39P mit Werten R3 bzw. R4. Die Spannungsteiler 34P, 34N sind mit Analogdigitalwandlern 36P, 36N verschaltet und mit einem Bezugspotential 45 verbunden. Die Komponenten 26N, 26P, 36N und 36P müssen nicht aus unterschiedlichen ADCs aufgebaut sein. Denkbar ist hier auch ein ADC mit einem 4:1 Multiplexer. Im Zusammenwirken ermitteln die Analogdigitalwandler 36P, 36N der Analogdigitalwandleranordnung 36 einen Wert für die Potentialdifferenz zwischen den ersten und zweiten Leitungen 31, 32 und somit zwischen den positiven und negativen Anschlüssen 31', 32' des DC-Ladenetzes 30. Die Spannungsteiler können unterschiedlich ausgeführt sein, z.B. mit 38N ungleich 38P und/oder mit 39N ungleich 39P.

Die Komponenten der Spannungsteiler 34P und 34N sowie der Analogdigitalwandleranordnung 36 des DC-Ladenetzes 30 müssen wiederum nicht hochgenau ausgelegt sein, weil die erforderliche Genauigkeit erfindungsgemäß über die Kalibrierung in Bezug auf die erste und hochgenaue Spannungsmesseinrichtung 15 des Hochspannungsnetzes 10 erfolgt.

Figur 2 zeigt ein Flussdiagramm einer Ausführungsform des erfindungsgemäßen Spannungsmessverfahrens S, zum Beispiel unter Verwendung des in Figur 1 dargestellten erfindungsgemäß ausgestalteten Bordnetzes 100.

Dieses Spannungsmessverfahrens S kann als Teil eines erfindungsgemäß ausgestalteten Betriebsverfahrens für den Betrieb eines Bordnetzes 100 mit einem Hochspannungsnetz 10 und mit mindestens einem weiteren Teilnetz 20, 30 aufgefasst und zum Beispiel wiederholt durchlaufen werden.

In einem ersten Schritt S1 der hier beschriebenen Ausführungsform des erfindungsgemäßen Spannungsmessverfahrens S werden bestimmte Parameter erfasst, die den Betrieb und/oder Zustand eines zu Grunde liegenden Fahrzeugs oder bestimmter Fahrzeugaggregate beschreiben.

Im nachfolgenden Schritt S2 wird geprüft, ob sich auf der Grundlage des erfassten Parametersatzes die Notwendigkeit des Durchführens einer Kalibrierung ergibt, zum Beispiel für eines erstes Teilnetz und insbesondere für ein Traktionsnetz 20 als Bestandteil eines zu Grunde liegenden Bordnetzes 100, wie dies im Zusammenhang mit Figur 1 beschrieben ist.

Wird diese Abfrage im Schritt S2 bejaht, so erfolgt eine Verzweigung zum Schritt S2a zum Durchführen der Kalibrierung der im Traktionsnetz 20 ausgebildeten Spannungsmesseinrichtung 25, nämlich in Bezug auf die hochgenaue Spannungsmesseinrichtung 15 des Hochspannungsnetzes 10 des Bordnetzes 100.

Wird die Abfrage im Schritt S2 verneint, so erfolgt keine Verzweigung, sondern es werden die nachfolgenden Prozessschritte abgearbeitet.

Die nachfolgenden Prozessschritte können optional, nämlich beim Vorliegen eines weiteren Teilnetzes im Bordnetz 100 und insbesondere beim Vorliegen eines Ladenetzes 30 oder eines Niederspannungsnetzes, in welchem ebenfalls eine Spannungsmessung mit einer Spannungsmesseinrichtung 35 durchgeführt werden kann, Schritte S3 und S3a des Abfragens des Vorliegens einer Notwendigkeit einer Kalibrierung für das weitere Teilnetz 30 bzw. des gegebenenfalls durchzuführenden Kalibrierens aufweisen.

Im weiteren Verlauf werden im nachfolgenden im Messbetrieb im Schritt S4 in einer jeweiligen Spannungsmesseinrichtung 25, 35 der Teilnetze 20 bzw. 30 Spannungswerte erfasst.

Bei den Kalibrierungen der Schritte S2a und S3a werden vorteihafterweise Beziehungen hergestellt zwischen den Kalibrierungsparametern und den Betriebsparametern und/oder Zustandsparametern zu den zum Zeitpunkt der Kalibrierungen vorliegenden Betriebsbedingungen und Zustandsbedingungen des zu Grunde liegenden Fahrzeugs und/oder der zu Grunde liegenden Aggregate. Auf diese Weise kann auch eine 1-zu-1-Zuordnung hergestellt werden zwischen den Betriebsparametern/Zustandsparametern einerseits und den Kalibrierungsparametern der Spannungsmesseinrichtungen 15, 25, 35 andererseits.

Darauffolgend werden im Schritt S5 auf der Grundlage der im Schritt S1 erfassten Parameter zu Betrieb und/oder Zustand des zu Grunde liegenden Fahrzeugs und/oder der zu Grunde liegenden Aggregate und der im Zusammenhang mit den Kalibrierungen der Schritte S2a und S3a erfassten entsprechende Kalibrierungsparameter aufgerufen und im nachfolgenden Schritt S6 zur Korrektur der im Schritt S4 erfassten Spannungswerte verarbeitet.

Die mit dem Spannungsmessverfahrens S abgeleiteten und korrigierten Spannungsmesswerte aus den Spannungsmesseinrichtungen 25, 35 der Teilnetze 20, 30 weisen auf Grund der Kalibrierung an der hochgenauen Spannungsmesseinrichtung 15 des Hochspannungsnetzes 10 ebenfalls ein höheres Maß an Genauigkeit auf, auch wenn die Komponenten der weiteren Spannungsmesseinrichtungen 25 und 35, so wie diese in der Figur 1 beschrieben sind, selbst als solche eine hohe Messgenauigkeit nicht zulassen.

Diese und weitere Merkmale und Eigenschaften der vorliegenden Erfindung werden an Hand der folgenden Darlegungen weiter erläutert:
Bei zukünftigen Batteriesystemen, insbesondere bei Elektrofahrzeugen oder Hybrid-Fahrzeugen, ist - im Gegensatz zum herkömmlichen Vorgehen - ein Einprägen von Spannungen auf abgeschaltete Teilnetze 10, 20, 30 eines Bordnetzes 100, zum Beispiel eines abgeschalteten Traktionsnetzes 20 oder eines abgeschalteten Ladenetzes 30, nicht mehr zulässig.

Um die Anzahl galvanisch getrennter Analogdigitalwandler für Spannungsmessungen und/oder dafür erforderlicher hochgenauer und daher kostenintensiver Spannungsteiler zu reduzieren, können in einem Bordnetz entsprechende Spannungen gegen bestimmte Potenziale gemessen werden, zum Beispiel gegen das Potential 45.

Hierbei treten jedoch unter anderem folgende Probleme auf:
(1) Es ist ein hinreichend hochohmiger und genauer Spannungsteiler zu verwenden. Insbesondere muss der Isolationswiderstand des Batteriesystems mindestens 2,5 MΩ betragen.
(2) Bei Hochspannungsbatteriesystemen und insbesondere bei 450V-Batteriesystemen ist eine Spannungsfestigkeit von mindestens 2150 V zu realisieren. Aufgrund des notwendigen hohen Teilerverhältnisses im Spannungsteiler zur Messung ergeben sich größere Messfehler.
(3) Durch die hochohmige Messung zwischen Traktionsnetz (TN) und dem Bezugspotenzial, zum Beispiel das Potential 45, sowie zwischen dem DC-Ladenetz (DC) und dem Bezugspotenzial, zum Beispiel das Potential 45, ergibt sich die Notwendigkeit einer differenziellen Messung und der Fehler bei der Verwendung eines Spannungsteilers geht doppelt ein.

Da erfindungsgemäß die Batteriespannung bezogen auf den negativen Pol der Batterie (Batterie-Minus) gemessen wird, wie dies im Zusammenhang mit Figur 1 und dort mit "HVP HV-ADC" bezeichnet ist, entfällt die unter (1) beschriebene Problematik.

Durch ein bei einer Ausführungsform der vorliegende Erfindung durchzuführendes und ggf. zyklisches Kalibrieren können alle relevanten Einflüsse - zum Beispiel in der Temperatur, der Alterung und/oder der Vibration - auf Widerstände und ihre Änderung bei doppelt auszubildenden Spannungsteilern 24N, 24P, 34N, 34P der weiteren Spannungsmesseinrichtungen 25, 35 vermieden werden.

Da die Temperaturen beim Abstellen eines zu Grunde liegen Fahrzeugs sich unterscheiden können von denjenigen beim Start, ist gemäß einer bevorzugten Ausführungsform der Erfindung das Anlegen einer Nachschlagetabelle, Auslesetabelle oder Look-Up-Tabelle von Vorteil.

In dieser Look-Up-Tabelle sind zum Beispiel einer jeweiligen Temperatur und/oder anderen Betriebsparameters entsprechend Korrekturfaktoren zugeordnet, um ein Kalibrieren und damit eine Abhängigkeit von einer Betriebstemperatur und/oder von weiteren Parametern zur Kompensation einfließen zu lassen.

Folglich ist erfindungsgemäß eine genauere Messung der TN-Spannungen und der DC-Spannungen, wie die Spannungen im Traktionsnetz 20 bzw. im DC-Ladenetz 30 auch genannt werden, möglich. Das erfordert - im Gegensatz zum herkömmlichen Vorgehen - keine zusätzliche teure Messelektronik.

Bei bevorzugten Ausführungsformen von Batteriesystemen 40 und entsprechenden Messverfahren können zusätzlich noch Abgänge mit eigener Sicherung vom Traktionsnetz 20 verwendet werden. Ein dabei gegebenenfalls einzusetzender zusätzlicher Diagnosekanal kann auch über das erfindungsgemäße Verfahren in seiner Messgenauigkeit gesteigert werden.

Das erfindungsgemäße Vorgehen liefert eine günstige Möglichkeit, eine Spannungsmessung am Traktionsnetz (TN) 20 und/oder am DC-Ladenetz (DC) 30 ohne die Notwendigkeit des Auftretens einer Batteriespannung und ohne zusätzliche teure galvanisch getrennte Analogdigitalwandler mit hoher Genauigkeit auszuführen.

Auch wenn die erfindungsgemäßen Aspekte und vorteilhaften Ausführungsformen anhand der in Verbindung mit den beigefügten Zeichnungsfiguren erläuterten Ausführungsbeispiele im Detail beschrieben worden sind, sind für den Fachmann Modifikationen und Kombinationen von Merkmalen der dargestellten Ausführungsbeispiele möglich, ohne den Bereich der vorliegenden Erfindung zu verlassen, deren Schutzbereich durch die beigefügten Ansprüche definiert wird.

### Bezugszeichenliste

- 10: Hochspannungsnetz
- 11: erste Leitung
- 11': positiver Anschluss
- 12: zweite Leitung
- 12': negativer Anschluss
- 14: Spannungsteiler
- 15: Spannungsmesseinrichtung
- 16: Analogdigitalwandler
- 17: Bezugspotenzial
- 18: Widerstand
- 19: Widerstand
- 20: weiteres Netz, Traktionsnetz
- 21: erste Leitung
- 21': positiver Anschluss
- 22: zweite Leitung
- 22': negativer Anschluss
- 23N: Schütz
- 23P: Schütz
- 23R: Ladewiderstand
- 23V: Schütz, Ladeschütz
- 24N: Spannungsteiler
- 24P: Spannungsteiler
- 25: Spannungsmesseinrichtung
- 26: Analogdigitalwandleranordnung
- 26N: Analogdigitalwandler
- 26P: Analogdigitalwandler
- 27N: Hochspannungsmesspunkt, -knoten
- 27P: Hochspannungsmesspunkt, -knoten
- 28N: Widerstand
- 28P: Widerstand
- 29N: Widerstand
- 29P: Widerstand
- 30: weiteres Netz, Ladenetz, DC-Ladenetz
- 31: erste Leitung
- 31': positiver Anschluss
- 32: zweite Leitung
- 32': negativer Anschluss
- 33N: Schütz
- 33P: Schütz
- 34N: Spannungsteiler
- 34P: Spannungsteiler
- 35: Spannungsmesseinrichtung
- 36: Analogdigitalwandleranordnung
- 36N: Analogdigitalwandler
- 36P: Analogdigitalwandler
- 37N: Hochspannungsmesspunkt, -knoten
- 37P: Hochspannungsmesspunkt, -knoten
- 38N: Widerstand
- 38P: Widerstand
- 39N: Widerstand
- 39P: Widerstand
- 40: Batterieeinheit
- 41: (erster) Kontakt
- 42: (zweiter) Kontakt
- 43: Batteriespannung, Hochspannung
- 45: Bezugspotential
- 100: Bordnetz
- R1: Widerstandswert
- R2: Widerstandswert
- R3: Widerstandswert
- R4: Widerstandswert

## Patentansprüche

1. Spannungsmessverfahren für ein aus einem Hochspannungsnetz (10) und mindestens einem weiteren Netz (20, 30) bestehendes Bordnetz (100) eines Fahrzeugs,
- wobei im Bordnetz (100)
(i) das Hochspannungsnetz (10) mit einer über eine erste Leitung (11) und über eine zweite Leitung (12) elektrisch mit einem positiven Anschluss (11`) bzw. einem negativen Anschluss (12') einer Hochspannungsquelle (40) elektrisch verbindbaren oder verbundenen Spannungsmesseinrichtung (15) ausgebildet ist und
(ii) das weitere Netz (20, 30) mit über Schütze (23N, 23P; 33N, 33P) mit der ersten Leitung (11) bzw. der zweiten Leitung (12) des Hochspannungsnetzes (10) elektrisch verbindbaren ersten bzw. zweiten Leitungen (21, 31; 22, 32) und mit einer mit diesen elektrisch verbindbaren oder verbundenen weiteren Spannungsmesseinrichtung (25, 35) ausgebildet ist,
- **dadurch gekennzeichnet, dass** beim Verfahren
(iii) in einem Kalibrationsbetrieb bei geschlossenen Schützen (23N, 23P; 33N, 33P) die Spannungsmesseinrichtung (25, 35) des weiteren Netzes (20, 30) gegen die Spannungsmesseinrichtung (15) des Hochspannungsnetzes (10) unter Ableitung mindestens eines Kalibrationsparameters kalibriert wird und
(iv) in einem Messbetrieb eine Spannungsmessung in dem weiteren Netz (20, 30) mit der Spannungsmesseinrichtung (25, 35) des weiteren Netzes (20, 30) und unter Abgleich mittels des Kalibrationsparameters durchgeführt wird, wobei
im Kalibrationsbetrieb ein jeweiliger Kalibrationsparameter gemeinsam mit einem oder mit mehreren Betriebsparametern des Hochspannungsnetzes (10) und/oder des weiteren Netzes (20, 30) erfasst wird, und wobei im Messbetrieb beim Abgleich über ein oder mehrere Betriebsparameter des Hochspannungsnetzes (10) und/oder des weiteren Netzes (20, 30) ein jeweiliger Kalibrationsparameter identifiziert und auf diesen zurückgegriffen wird.

2. Spannungsmessverfahren nach Anspruch 1,
bei welchem im Kalibrationsbetrieb erfasste Kalibrationsparameter in einer Nachschlagetabelle gespeichert werden.

3. Spannungsmessverfahren nach einem der vorangehenden Ansprüche, bei welchem
- ein jeweiliger Kalibrationsparameter als Faktor abgeleitet wird und
- im Messbetrieb ein Abgleich dadurch erfolgt, dass der Wert einer durch die Spannungsmesseinrichtung (25, 35) des weiteren Netzes (20, 30) ermittelten Spannung mit dem Kalibrationsparameter multipliziert wird, um einen korrigierten Wert der Spannung zu erhalten.

4. Spannungsmessverfahren nach einem der vorangehenden Ansprüche, bei welchem
- ein Kalibrationsbetrieb wiederholt durchgeführt wird,
- wenn ein oder mehrere Kriterien aus der Gruppe von Kalibrationskriterien erfüllt sind, welche zumindest die Kriterien aufweist:
(i) der Wert einer Betriebstemperatur eines zu Grunde liegenden Fahrzeugs und/oder eines Aggregats des Fahrzeugs liegt außerhalb einer bestimmten Wertemenge,
(ii) der Betrieb des Fahrzeugs und/oder eines Aggregats des Fahrzeugs wurde erstmalig begonnen,
(iii) der Betrieb des Fahrzeugs und/oder eines Aggregats des Fahrzeugs wurde erneut begonnen nach Verstreichen einer vorgegebenen Zeitspanne,
(iv) es ist eine bestimmte Zeitspanne seit einer letzten Kalibration verstrichen,
(v) der Wert der Abweichung zwischen einem mit der Spannungsmesseinrichtung (15) des Hochspannungsnetzes (10) bestimmten Wert und einem mit der Spannungsmesseinrichtung (25, 35) des weiteren Netzes (20, 30) bestimmten Wert liegt außerhalb einer vorgegebenen Wertemenge.

5. Spannungsmessverfahren nach einem der vorangehenden Ansprüche,
bei welchem das mindestens eine weitere Netz (20, 30) gebildet wird von einem Traktionsnetz (20) und/oder von einem Ladenetz (30).

6. Betriebsverfahren für ein aus einem Hochspannungsnetz (10) und mindestens einem weiteren Netz (20, 30) bestehendes Bordnetz (100) eines Fahrzeugs, bei welchem
- der Betrieb des Hochspannungsnetzes (10) und/oder des mindestens einen weiteren Netzes (20, 30) über ein Erfassen von Spannungswerten überwacht und/oder gesteuert wird und
- zum Erfassen der Spannungswerte ein Spannungsmessverfahren nach einem der vorangehenden Ansprüche verwendet wird.

7. Steuereinheit für ein aus einem Hochspannungsnetz (10) und mindestens einem weiteren Netz (20, 30) bestehendes Bordnetz (100) eines Fahrzeugs, welche eingerichtet ist, ein Spannungsmessverfahren nach einem der Ansprüche 1 bis 5 und/oder ein Betriebsverfahren nach Anspruch 6 auszuführen.

8. Bordnetz (100) für ein Fahrzeug, welches ein Hochspannungsnetz (10) und mindestens ein weiteres Netz (20, 30) aufweist und welches mit einer Steuereinheit nach Anspruch 7 zur Steuerung des Betriebs, des Ladens und/oder Entladens einer zu Grunde liegenden Batterieeinheit (40) ausgebildet ist.

9. Fahrzeug mit einem Aggregat und mit einem Bordnetz (100) nach Anspruch 8 zur Versorgung des Aggregats mit elektrischer Energie.

## Claims

1. Voltage measurement method for an on-board network (100) of a vehicle, said on-board network consisting of a high-voltage network (10) and at least one further network (20, 30),
- wherein, in the on-board network (100),
(i) the high-voltage network (10) is designed so as to have a voltage measurement device (15) which is electrically connected or able to be connected, via a first line (11) and via a second line (12), electrically to a positive connection (11') and to a negative connection (12'), respectively, of a high-voltage source (40) and
(ii) the further network (20, 30) is designed to have first and second lines (21, 31; 22, 32) which are able to be electrically connected, via contactors (23N, 23P; 33N, 33P), to the first line (11) and to the second line (12), respectively, of the high-voltage network (10), and to have a further voltage measurement device (25, 35) which is electrically connected or able to be connected to said first and second lines (21, 31; 22, 32),
- **characterized in that**, in the method,
(iii) in a calibration mode with closed contactors (23N, 23P; 33N, 33P), the voltage measurement device (25, 35) of the further network (20, 30) is calibrated against the voltage measurement device (15) of the high-voltage network (10) so as to derive at least one calibration parameter and,
(iv) in a measurement mode, voltage measurement in the further network (20, 30) is carried out using the voltage measurement device (25, 35) of the further network (20, 30) and so as to adjust by means of the calibration parameter, wherein,
in the calibration mode, a respective calibration parameter is acquired together with one or with a plurality of operating parameters of the high-voltage network (10) and/or of the further network (20, 30), and wherein, in the measurement mode, while adjusting by one or more operating parameters of the high-voltage network (10) and/or of the further network (20, 30), a respective calibration parameter is identified and referred to.

2. Voltage measurement method according to Claim 1,
in which calibration parameters acquired in the calibration mode are stored in a lookup table.

3. Voltage measurement method according to either of the preceding claims, in which
- a respective calibration parameter is derived as a factor and,
- in the measurement mode, an adjustment is made whereby the value of a voltage ascertained by the voltage measurement device (25, 35) of the further network (20, 30) is multiplied by the calibration parameter in order to obtain a corrected value of the voltage.

4. Voltage measurement method according to one of the preceding claims, in which
- a calibration mode is carried out repeatedly
- if one or more criteria from the group of calibration criteria are met, said group comprising at least the following criteria:
(i) the value of an operating temperature of an underlying vehicle and/or of a unit of the vehicle lies outside a particular value set,
(ii) operation of the vehicle and/or of a unit of the vehicle was started for the first time,
(iii) operation of the vehicle and/or of a unit of the vehicle was restarted after a predefined period of time has elapsed,
(iv) a particular period of time has elapsed since last calibration,
(v) the value of the difference between a value determined by the voltage measurement device (15) of the high-voltage network (10) and a value determined by the voltage measurement device (25, 35) of the further network (20, 30) lies outside a predefined value set.

5. Voltage measurement method according to one of the preceding claims,
in which the at least one further network (20, 30) is formed of a traction network (20) and/or of a charging network (30).

6. Operating method for an on-board network (100) of a vehicle, said on-board network consisting of a high-voltage network (10) and at least one further network (20, 30), in which operating method
- operation of the high-voltage network (10) and/or of the at least one further network (20, 30) is monitored and/or controlled by acquiring voltage values and
- the voltage values are acquired using a voltage measurement method according to one of the preceding claims.

7. Control unit for an on-board network (100) of a vehicle, said on-board network consisting of a high-voltage network (10) and at least one further network (20, 30), which control unit is configured to perform a voltage measurement method according to one of Claims 1 to 5 and/or an operating method according to Claim 6.

8. On-board network (100) for a vehicle, which has a high-voltage network (10) and at least one further network (20, 30) and which is designed to have a control unit according to Claim 7 for controlling the operation, the charging and/or discharging of an underlying battery unit (40).

9. Vehicle having a unit and having an on-board network (100) according to Claim 8 for supplying electrical energy to the unit.

## Revendications

1. Procédé de mesure de tension destiné à un réseau de bord (100) d'un véhicule qui comprend un réseau à haute tension (10) et au moins un autre réseau (20, 30),
- dans le réseau de bord (100)
(i) le réseau à haute tension (10) étant conçu avec un dispositif de mesure de tension (15) qui est relié ou peut être relié électriquement par une première ligne (11) et par une deuxième ligne (12) à une borne positive (11'), respectivement une borne négative (12'), d'une source de haute tension (40) et
(ii) l'autre réseau (20, 30) étant conçu avec des premières, respectivement deuxièmes, lignes (21, 31 ; 22, 32) qui peuvent être reliées électriquement par le biais de contacteurs (23N, 23P ; 33N, 33P) à la première ligne (11), respectivement à la deuxième ligne (12), du réseau à haute tension (10) et avec un autre dispositif de mesure de tension (25, 35) qui est relié ou peut être relié électriquement auxdites lignes,
- **caractérisé en ce que** dans le procédé (iii) lors d'une opération d'étalonnage avec les contacteurs (23N, 23P ; 33N, 33P) fermés, le dispositif de mesure de tension (25, 35) de l'autre réseau (20, 30) est étalonné par rapport au dispositif de mesure de tension (15) du réseau à haute tension (10) par déduction d'au moins un paramètre d'étalonnage et
(iv) lors d'une opération de mesure, une mesure de tension est effectuée dans l'autre réseau (20, 30) avec le dispositif de mesure de tension (25, 35) de l'autre réseau (20, 30) et par réglage à l'aide du paramètre d'étalonnage,
dans le mode d'étalonnage, un paramètre d'étalonnage respectif étant détecté avec un ou plusieurs paramètres de fonctionnement du réseau à haute tension (10) et/ou de l'autre réseau (20, 30), et
lors de l'opération de mesure, un paramètre d'étalonnage respectif étant identifié et utilisé lors du réglage d'un ou plusieurs paramètres de fonctionnement du réseau à haute tension (10) et/ou de l'autre réseau (20, 30).

2. Procédé de mesure de tension selon la revendication 1, dans lequel les paramètres d'étalonnage détectés pendant l'opération d'étalonnage sont mémorisés dans une table de recherche.

3. Procédé de mesure de tension selon l'une des revendications précédentes, dans lequel
- un paramètre d'étalonnage respectif est déduit comme facteur et
- dans l'opération de mesure, un réglage est effectué par multiplication de la valeur d'une tension déterminée par le dispositif de mesure de tension (25, 35) de l'autre réseau (20, 30) par le paramètre d'étalonnage afin d'obtenir une valeur corrigée de la tension.

4. Procédé de mesure de tension selon l'une des revendications précédentes, dans lequel
- une opération d'étalonnage est effectuée à plusieurs reprises,
- si un ou plusieurs critères de l'ensemble de critères d'étalonnage sont remplis, lequel ensemble comporte au moins les critères suivants :
(i) la valeur d'une température de fonctionnement d'un véhicule sous-jacent et/ou d'un groupe du véhicule se situe en dehors d'un ensemble de valeurs déterminé,
(ii) le fonctionnement du véhicule et/ou d'un groupe du véhicule a démarré pour la première fois,
(iii) le fonctionnement du véhicule et/ou d'un groupe du véhicule a été redémarré après qu'un intervalle de temps spécifiée s'est écoulé,
(iv) un intervalle de temps déterminé s'est écoulé depuis un dernier étalonnage,
(v) la valeur de l'écart entre une valeur déterminée avec le dispositif de mesure de tension (15) du réseau à haute tension (10) et une valeur déterminée avec le dispositif de mesure de tension (25, 35) de l'autre réseau (20, 30) est située à l'extérieur d'un ensemble de valeurs spécifié.

5. Procédé de mesure de tension selon l'une des revendications précédentes, dans lequel l'au moins un autre réseau (20, 30) est formé par un réseau de traction (20) et/ou par un réseau de charge (30).

6. Procédé de fonctionnement d'un réseau de bord (100) d'un véhicule, comprenant un réseau à haute tension (10) et au moins un autre réseau (20, 30), procédé dans lequel
- le fonctionnement du réseau à haute tension (10) et/ou de l'au moins un autre réseau (20, 30) est surveillé et/ou commandé par détection de valeurs de tension et
- un procédé de mesure de tension selon l'une des revendications précédentes est utilisé pour détecter les valeurs de tension.

7. Unité de commande d'un réseau de bord (100) d'un véhicule, laquelle comprend un réseau à haute tension (10) et au moins un autre réseau (20, 30) et est adaptée pour mettre en œuvre un procédé de mesure de tension selon l'une des revendications 1 à 5 et/ou un procédé de fonction selon la revendication 6.

8. Réseau de bord (100) qui est destiné à un véhicule, qui comprend un réseau à haute tension (10) et au moins un autre réseau (20, 30) et qui est conçu avec une unité de commande selon la revendication 7 destinée à commander le fonctionnement, la charge et/ou la décharge d'une unité de batterie sous-jacente (40).

9. Véhicule comprenant un groupe et un réseau de bord (100) selon la revendication 8 destiné à alimenter le groupe en énergie électrique.
